# EUROPEAN PATENT SPECIFICATION

(11) **EP 2 853 442 B1**
(45) Date of publication and mention of the grant of the patent: **02.08.2017**
(21) Application number: 14003270.7
(22) Date of filing: 22.09.2014
(51) Int. Cl.: H05K 3/20, H05K 3/04, H05K 1/02, H01L 23/31, H01L 23/495, H01L 21/48

(54) **Insert molded circuit and method of producing an insert molded circuit**
Umspritzter Schaltkreis und Verfahren zur Herstellung eines umspritzten Schaltkreises
Circuit isolé par moulage et procédé de production associé

(30) Priority: 25.09.2013 JP 2013198530
(43) Date of publication of application: 01.04.2015
(73) Proprietor: KABUSHIKI KAISHA TOKAI RIKA DENKI SEISAKUSHO, Niwa-gun, Aichi 480-0195 (JP)
(72) Inventor: Hishikawa, Koji, Aichi 480-0195 (JP); Nagano, Akira, Aichi 480-0195 (JP)
(74) Representative: Samson & Partner Patentanwälte mbB

(56) References cited:
- WO-A1-2013/024683
- DE-A1- 3 943 261
- US-A- 3 465 091
- US-A1- 2004 043 536
- US-A1- 2009 017 647

## Description

### BACKGROUND

The present invention relates to an insulator in which a plurality of conductors are provided by insert molding, and a method of producing the insulator.

An insulator disclosed in JP-A-2001-179774, for example, is produced by insert molding a conductor forming member in which parts for forming conductors are integrally connected, and thereafter, by erecting and cutting a connecting part of the conductor forming member.

However, in the insulator which has been produced by the production method as described above, a plurality of the conductors are separated only by way of a slight gap which is formed in the erected part. For this reason, there is such anxiety that in case where frosting occurs in the gap or foreign substance such as dust adheres to the gap, for example, an unintended circuit may be formed between the conductors, which may cause a malfunction.

The closest prior art is disclosed in document US-A1-2004/043536.

### SUMMARY

The invention has been made in view of the above described circumstances, and an object of the invention is to provide an insulator capable of realizing such a structure that the unintended circuit is hardly formed between conductors and thus, probability of occurring malfunction is reduced, even in case where the insulator is produced by insert molding a conductor forming member in which parts for forming the conductors are integrally connected, and thereafter, by forming gaps in a connecting part of the member, and also, to provide a method of producing the insulator.

In order to attain the above described object, there is provided an insert molded product as defined in claim 1. For example, a wall part 12 of the insulating material is provided between the gaps 10,11 of the connecting part 7.

Moreover, there is provided a method of producing an insert molded product as defined in claim 3. For example, the connecting part 7 is divided into a plurality of connecting portions by the plurality of gaps 10,11, and the plurality of connecting portions are electrically separated to each other.

According to the invention, by removing the plurality of the parts of the connecting part which connects the plurality of conductor forming parts, the plurality of conductors are formed in the insulator. As the results, in the insulator which has been thus produced, the plurality of gaps are formed between the plurality of conductors. In this case, probability that frosting may occur simultaneously in the plurality of gaps which are formed between the conductors, or foreign substance may adhere simultaneously to the gaps is extremely low. Therefore, unless frosting occurs simultaneously in a plurality of the gaps, or unless dust adheres simultaneously to the gaps, unintended circuits will not be formed between the conductors. In this manner, it is possible to realize the insulator having such a structure that unintended circuits are hardly formed between the conductors, and hence, probability of occurring malfunctions can be remarkably reduced.

### BRIEF DESCRIPTION OF THE DRAWINGS

Fig. 1 is a view schematically showing an example of an insulator according to an embodiment of the invention.
Fig. 2 is a view schematically showing an example of a terminal forming member.
Fig. 3 is a view showing an example of the insulator in a state where the terminal forming member is provided by insert molding.
Fig. 4 is a sectional view of the insulator taken along a line A-A in Fig. 1.

### DETAILED DESCRIPTION OF EXEMPLARY EMBODIMENTS

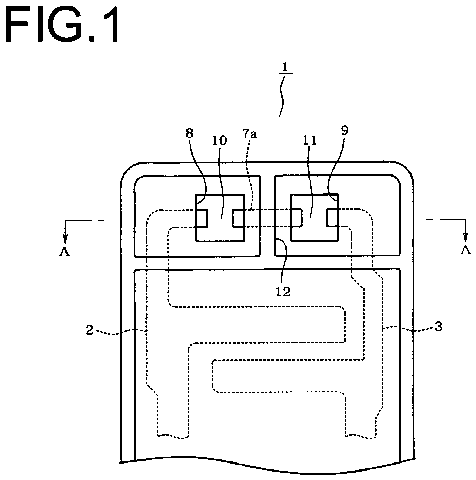

Now, an embodiment of the invention will be described, referring to the drawings. As shown in Fig. 1, for example, terminals 2, 3 which are examples of conductors are embedded in the insulator 1, by so-called insert molding. Although not shown in the drawing, a part of each of the terminals 2, 3 is exposed from the insulator 1. The exposed parts function as fixed contacts with respect to a movable contact which is not shown.

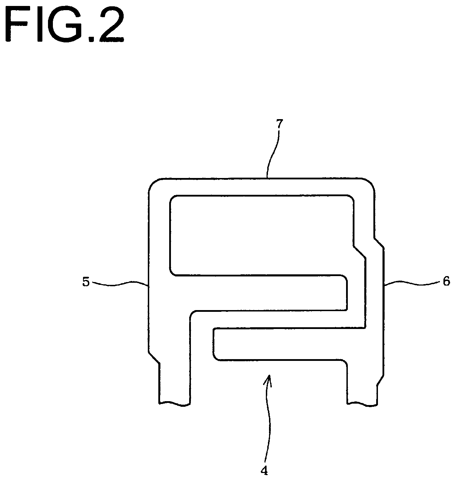

These terminals 2, 3 are obtained, for example, from a part of a terminal forming member 4 which is shown in Fig. 2. Specifically, the terminal forming member 4 is an example of a conductor forming member, and formed of conductive material such as metal in its entirety. This terminal forming member 4 includes a terminal forming part 5 for forming the terminal 2, a terminal forming part 6 for forming the terminal 3, and a connecting part 7 which integrally connects these terminal forming parts 5 and 6 to each other. The terminal forming parts 5, 6 are examples of the conductor forming parts. The connecting part 7 linearly connects the terminal forming part 5 and the terminal forming part 6 to each other. It is to be noted that such connecting parts can be provided in plurality, according to shapes, numbers, positions to be arranged, and so on of the terminal forming parts which are contained in the terminal forming member 4, although not shown in the drawings. It is also possible to appropriately modify a shape of the connecting part, when the insulator is put into practice.

The insulator 1 as described above can be produced by a production method including the following processes, for example. An example of the production method of this insulator 1 will be described below.

### <Insert molding process of the terminal forming member>

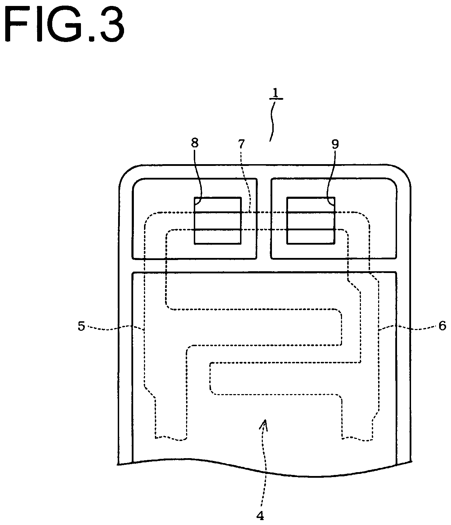

In this process, the terminal forming member 4 is placed at a predetermined position in a molding cavity for molding the insulator, which is not shown. In this state, a resin is injected into the molding cavity, and the injected resin is hardened. As the results, a state where the terminal forming member 4 is embedded in a main body of the insulator 1 is obtained, as shown in Fig. 3. The main body of the insulator 1 is provided with trimming holes 8, 9 which pass through the main body of the insulator 1 in a direction of thickness which is perpendicular to a plane in which the terminal forming member 4 is placed, at positions corresponding to the connecting part 7 of the terminal forming member 4. In this embodiment, the two trimming holes 8, 9 are provided for the one connecting part 7. Specifically, the number of the trimming holes 8, 9 for the single connecting part 7 is set to be two, in this case. It is to be noted that the number of the trimming holes which are formed for the one connecting part is not limited to two, but may be three, four or more, for example, provided that a plurality of the trimming holes are formed. Moreover, a shape of the trimming hole is not limited to a rectangular shape, but may be appropriately modified, for example, to a round shape, an elliptical shape, a polygonal shape, etc., when the insulator is put into practice.

### <Trimming process>

This process is a process which is conducted succeeding the above described "Insert molding process of the terminal forming member". Specifically, after the terminal forming member 4 has been embedded in the main body of the insulator 1 by insert molding, a plurality of regions (two regions in this embodiment) of the connecting part 7 are subjected to trimming, that is, removed through a plurality of the trimming holes 8, 9. In this manner, a plurality of the regions of the connecting part 7 are removed thereby to separate the terminal forming part 5 from the terminal forming part 6. As the results, the insulator 1 in which the terminals 2, 3 are embedded by insert molding, as shown in Fig. 1, for example, can be obtained.

In the insulator 1 which has been produced according to this production method, a plurality of the regions of the relevant connecting part 7 are removed, in the same connecting part 7. Because the two regions are removed, in this case, a plurality of gaps, namely, two gaps 10, 11 are formed between the terminal 2 and the terminal 3. A remaining part 7a which is formed between the gap 10 and the gap 11 is not removed from the insulator 1, but remains in the insulator 1. Therefore, such a state that a plurality of the gaps 10, 11 are formed between the terminal 2 and the terminal 3 is maintained.

According to this embodiment, by removing a plurality of the regions of the connecting part 7 which connects a plurality of the terminal forming parts 5, 6, a plurality of the terminals 2, 3 are formed in the insulator 1. As the results, in the insulator 1 which has been thus produced, a plurality of the gaps 10, 11 are formed between a plurality of the terminals 2 and 3. In this case, there is extremely low probability that frosting occurs simultaneously in both the gap 10 and the gap 11 which are formed between the terminals 2 and 3, or foreign substance adheres simultaneously to the gaps. Therefore, unless frosting occurs simultaneously in a plurality of the gaps 10, 11, or unless dust adheres simultaneously to the gaps, unintended circuits are not formed between the terminals 2 and 3. In this manner, it is possible to realize the insulator 1 having such a structure that unintended circuits are hardly formed between the terminals 2 and 3, and it is possible to remarkably reduce probability of occurring malfunction.

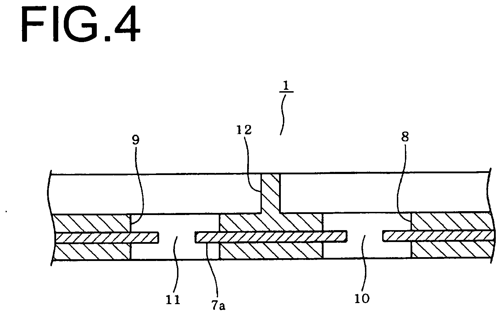

Moreover, as shown in Fig. 4, for example, there is formed a wall part 12 between a plurality of the trimming holes 8, 9 in the insulator 1, that is, between the positions where the gaps 10, 11 are formed by removing parts of the connecting part 7. Accordingly, a plurality of the gaps 10, 11 are isolated from each other by this wall part 12. As the results, it is possible to further prevent such phenomenon that frosting occurs simultaneously in a plurality of the gaps 10, 11 or dust adheres simultaneously to the gaps. In other words, it is further possible to prevent occurrence of unintended circuits between the terminals 2 and 3.

Moreover, the wall part 12 is provided in an upper part of the insulator 1, in a state where the insulator 1 is mounted on an object to be mounted, such as a vehicle. Further, the wall part 12 is provided so as to extend upward in the insulator 1, in a state where the insulator 1 is mounted on the object. In many cases, the foreign substance such as frost or dust falls with gravity, and adheres to the upper part of the insulator 1. Therefore, in the upper part of the insulator 1 to which the frost or the dust is likely to adhere, a plurality of the gaps 10, 11 are isolated from each other by the wall part 12. Accordingly, it is possible to further prevent such phenomenon that frosting occurs simultaneously in a plurality of the gaps 10, 11 or dust adheres simultaneously to the gaps. In other words, it is further possible to prevent occurrence of unintended circuits between the terminals 2 and 3.

Moreover, this wall part 12 also functions as a rib for reinforcing the insulator 1. In designing the insulator 1, it is possible to appropriately modify a height and a width of this wall part 12. Moreover, in designing the insulator 1, it is possible to appropriately change a position of this wall part 12, for example, to an intermediate position between the gap 10 and the gap 11, or to a position close to either one of the gap 10 and the gap 11. It is also possible to provide a plurality of the wall parts between a plurality of the gaps.

For reference, in case where the remaining part 7a of the connecting part 7 is removed in the above described insulator 1, a gap which is larger than the gaps 10, 11 is formed between the terminals 2 and 3, but the number of the gap is only one. When frosting occurs or dust adheres to this only one gap, an unintended circuit may be formed between the terminals 2 and 3. On the other hand, in the insulator 1 according to this embodiment, a plurality of the gaps are provided between the terminals 2 and 3, although they are small gaps. Therefore, there is extremely low possibility that the frost or dust simultaneously adheres to a plurality of the gaps, and hence, it is possible to realize such a structure that an unintended circuit is hardly formed between the terminals 2 and 3.

## Claims

1. An insert molded product 1 which is obtained by insert molding a conductor forming member 4 with an insulating material, in which a plurality of conductor forming parts 5, 6 for forming conductors are integrally connected by a connecting part 7, and
thereafter, by removing a plurality of parts of the connecting part 7,
wherein a plurality of gaps 10, 11 are formed in the connecting part 7; and
wherein the connecting part 7 is divided into a plurality of connecting portions by the plurality of gaps 10, 11 so that the plurality of connecting portions are electrically separated from each other;
**characterized in that** a remaining part 7a which is formed between the plurality of gaps 10, 11 remains in the insert molded product.

2. The insert molded product according to claim 1, comprising a wall part 12 between the gaps 10, 11 of the connecting part 7, wherein the wall part 12 is formed of the insulating material.

3. A method of producing an insert molded product, comprising the steps of:
insert molding a conductor forming member 4 with an insulating material, in which a plurality of conductor forming parts 5,6 for forming the conductors are integrally connected by a connecting part 7; and thereafter,
removing a plurality of parts of the connecting part 7 to form a plurality of gaps 10, 11, and wherein the connecting part 7 is divided into a plurality of connecting portions by the plurality of gaps 10,11 so that the plurality of connecting portions are electrically separated from each other; and thereby
forming a remaining part 7a between the plurality of gaps 10, 11,
and **characterized in that** the remaining part 7a remains in the insert molded product.

## Patentansprüche

1. Umspritztes Erzeugnis 1, das durch Umspritzen eines leiterformenden Elements 4 mit einem isolierenden Material, in dem eine Vielzahl von leiterformenden Teilen 5, 6 zum Formen von Leitern, durch ein Verbindungsteil 7 integral verbunden sind und anschließend durch Entfernen einer Vielzahl von Teilen des Verbindungsteils 7 erhalten wird,
wobei eine Vielzahl von Lücken 10, 11 in dem Verbindungsteil 7 ausgebildet sind; und
wobei das Verbindungsteil 7 durch die Vielzahl von Lücken 10, 11 in eine Vielzahl von Verbindungsbereichen unterteilt ist, so dass die Vielzahl von Verbindungsbereichen elektrisch voneinander getrennt ist;
**dadurch gekennzeichnet, dass**
ein Restteil 7a, das zwischen der Vielzahl von Lücken 10, 11 ausgebildet ist, in dem umspritzten Erzeugnis verbleibt.

2. Umspritztes Erzeugnis nach Anspruch 1, umfassend ein Wandteil 12 zwischen den Lücken 10, 11 des Verbindungsteils 7, wobei das Wandteil 12 aus dem isolierenden Material geformt ist.

3. Verfahren zum Erzeugen eines umspritzten Erzeugnisses, umfassend die Schritte:
Umspritzen eines leiterformenden Elements 4 mit einem isolierenden Material, in dem eine Vielzahl von leiterformenden Teilen 5, 6 zum Formen der Leiter durch einen Verbindungsteil 7 integral verbunden werden; und anschließend
Entfernen einer Vielzahl von Teile des Verbindungsteils 7, um eine Vielzahl von Lücken 10, 11 auszubilden und wobei das Verbindungsteil 7 durch die Vielzahl von Lücken 10, 11 in eine Vielzahl von Verbindungsteile unterteilt ist, so dass die Vielzahl von Verbindungsteile elektrisch voneinander getrennt ist; und dadurch
Ausbilden eines Restteils 7a zwischen der Vielzahl von Lücken 10, 11;
und **dadurch gekennzeichnet, dass** das Restteil 7a in dem umspritzten Erzeugnis verbleibt.

## Revendications

1. Produit moulé par insertion (1) qui est obtenu en moulant par insertion un élément formant conducteur (4) avec un matériau isolant, dans lequel une pluralité de parties formant conducteur (5, 6) pour former des conducteurs sont raccordées de manière solidaire par une partie de raccordement (7), et ensuite, en retirant une pluralité de parties de la partie de raccordement (7),
dans lequel une pluralité d'espaces (10, 11) sont formés dans la partie de raccordement (7) ; et
dans lequel la partie de raccordement (7) est divisée en une pluralité de parties de raccordement par la pluralité d'espaces (10, 11) de sorte que la pluralité de parties de raccordement sont électriquement séparées les unes des autres ;
**caractérisé en ce que** :
une partie résiduelle (7a) qui est formée entre la pluralité d'espaces (10, 11) reste dans le produit moulé par insertion.

2. Produit moulé par insertion selon la revendication 1, comprenant une partie de paroi (12) entre les espaces (10, 11) de la partie de raccordement (7), dans lequel la partie de paroi (12) est formée avec un matériau isolant.

3. Procédé pour produire un produit moulé par insertion, comprenant les étapes suivantes :
mouler par insertion un élément conducteur (4) avec un matériau isolant, dans lequel une pluralité de parties formant conducteur (5, 6) pour former les conducteurs sont raccordées de manière solidaire par une partie de raccordement (7) ; et après quoi :
retirer une pluralité de parties de la partie de raccordement (7) pour former une pluralité d'espaces (10, 11), et dans lequel la partie de raccordement (7) est divisée en une pluralité de parties de raccordement par la pluralité d'espaces (10, 11), de sorte que la pluralité de parties de raccordement sont électriquement séparées les unes des autres ; et ainsi :
former une partie résiduelle (7a) entre la pluralité d'espaces (10, 11), et **caractérisé en ce que** la partie résiduelle (7a) reste dans le produit moulé par insertion.
